# EUROPÄISCHE PATENTSCHRIFT

(11) **EP 0 681 318 B1**
(45) Veröffentlichungstag und Bekanntmachung des Hinweises auf die Patenterteilung: **27.11.1996**
(21) Anmeldenummer: 95106337.9
(22) Anmeldetag: 27.04.1995
(51) Int. Cl.: H01L 21/306

(54) **Verfahren zur Behandlung von Halbleitermaterial mit einer säurehaltigen Flüssigkeit**
Process for treating a semiconducting material with an acid containing liquid
Procédé pour le traitement de matériaux semi-conducteurs à l'aide d'un liquide contenant de l'acide

(30) Priorität: 28.04.1994 DE 4414925
(43) Veröffentlichungstag der Anmeldung: 08.11.1995
(73) Patentinhaber: Wacker Siltronic Gesellschaft für Halbleitermaterialien Aktiengesellschaft, 84489 Burghausen (DE)
(72) Erfinder: Stadler, Maximilian, Dr., D-84533 Haiming (DE); Schwab, Günther, D-84547 Emmerting (DE); Romeder, Peter, D-84489 Burghausen (DE); Trifellner, Gabriele, D-84543 Winhöring (DE)
(74) Vertreter: Rimböck, Karl-Heinz, Dr.

(56) Entgegenhaltungen:
- FR-A- 2 273 081
- PATENT ABSTRACTS OF JAPAN vol. 005 no. 032 (P-050) ,27.Februar 1981 & JP-A-55 154452 (SEIKO KAKOKI KK) 2.Dezember 1980,

## Beschreibung

Die Erfindung betrifft ein Verfahren zur Behandlung von Halbleitermaterial mit einer säurehaltigen Flüssigkeit unter Bildung von Wasser als Produkt einer chemischen Reaktion.

Die Bereitstellung geeigneter Grundstoffe, aus denen elektronische Bauteile hergestellt werden können, erfordert regelmäßig Verfahrensschritte, während derer Halbleitermaterial mit säurehaltigen Flüssigkeiten behandelt werden muß.

In der FR-2 273 081 ist ein Verfahren zum Ätzen von Halbleitermaterial beschrieben, mit dem siliciumhaltige Feststoffe selektiv geätzt werden können. Das Ätzmittel besteht aus einer schmelzflüssig heißen Masse aus wasserfreier Phosphorsäure und mindestens 12% Phosphorpentoxid.
Aus den Patent Abstracts Of Japan, Band 5, Nr.32, (P-050) und der JP-A-55 154 452 ist ein Verfahren zur Überwachung der Konzentration eines gelösten Salzes einer Halogensäure mit Hilfe einer pH-stabilisierten, Wasserstoffperoxid enthaltenden Lösung bekannt.

Die Behandlungen können unterschiedliche Ziele verfolgen. Sie werden beispielsweise dazu eingesetzt, um die Kristallstruktur des Halbleitermaterials zu analysieren oder um Fehlordnungen im Kristall aufzudecken. Sie dienen auch dazu, Verunreinigungen von der Oberfläche des Halbleitermaterials zu lösen oder oberflächennahe Schichten, deren Kristallstruktur in Folge mechanischer Einflüsse gestört wurde, abzutragen. Ein weiteres Ziel der Behandlung von Halbleitermaterial mit säurehaltigen Flüssigkeiten ist das Bereitstellen von Halbleiterscheiben mit völlig glatt geätzten Seitenflächen.

Zum Erreichen der genannten Ziele ist es notwendig, daß die eingesetzte säurehaltige Flüssigkeit in der Lage ist, das entsprechende Halbleitermaterial chemisch aufzulösen. In der Regel entsteht bei diesem Vorgang unter anderem Wasser als Produkt einer chemischen Reaktion. Das sich bildende Wasser reichert sich in der säurehaltigen Flüssigkeit an und beeinflußt den weiteren Fortgang der Behandlung des Halbleitermaterials. Häufig verringert sich die Geschwindigkeit des Materialabtrags, so daß längere Behandlungszeiten in Kauf genommen werden müssen oder die eingesetzte Behandlungsflüssigkeit früher ersetzt werden muß. Beides treibt die Produktionskosten in die Höhe. Ein steigender Wassergehalt in der säurehaltigen Flüssigkeit kann sich auch auf das Ergebnis der Behandlung von Halbleiterscheiben nachteilig auswirken. Untersucht man beispielsweise die Seitenflächen von Siliciumscheiben, die mit einer Flußsäure und Salpetersäure enthaltenden Flüssigkeit behandelt wurden, stellt man fest, daß die verbleibende Rauhigkeit der Oberflächen mit dem Wassergehalt im Behandlungsmittel korreliert. Lag der Wassergehalt unter sonst unveränderten Bedingungen höher, ist auch Restrauhigkeit der Seitenflächen der Siliciumscheiben größer.

Die Aufgabe der Erfindung bestand deshalb darin, ein Verfahren anzugeben, mit dem dieser Nachteil vermieden werden kann.

Die Aufgabe wird durch ein Verfahren gemäß Anspruch 1 gelöst.
Die Zugabe des Phosphorpentoxids kann vor und/oder während der Behandlung des Halbleitermaterials erfolgen.

Unter dem Begriff "Behandlung von Halbleitermaterial" im Sinne der Erfindung ist das Inkontaktbringen von Halbleitermaterial und säurehaltiger Flüssigkeit zu verstehen. Dies kann insbesondere dadurch geschehen, daß das Halbleitermaterial in die säurehaltige Flüssigkeit getaucht oder mit dieser besprüht wird.

In der Regel ist ein bestimmter, jedoch niedriger Wassergehalt in der säurehaltigen Flüssigkeit (nachfolgend "Ätzmittel" genannt) erwünscht und notwendig, damit das Halbleitermaterial mit einer zufriedenstellenden Geschwindigkeit geätzt wird. Deshalb ist ein Wassergehalt im Ätzmittel von maximal 20 Gew.-% durchaus tolerierbar. Mit der Zugabe von Phosphorpentoxid zum Ätzmittel wird zum einen sichergestellt, daß der Wassergehalt während der Behandlung des Halbleitermaterials nicht über die Marke von 20 Gew.-% ansteigt. Zum anderen hat es sich gezeigt, daß die durch chemische Reaktion von Wasser und Phosphorpentoxid entstehende Phosphorsäure das Fließverhalten des Ätzmittels günstig beeinflußt und zu einer Verbesserung von dessen oberflächenglättender Wirkung beiträgt.

Darüber hinaus ist es häufig zweckmäßig, beim Abmischen des Ätzmittels, statt konzentrierter Säuren, ihre einfacher handhabbaren, wässerigen Lösungen zu verwenden. In solchen Fällen wird der Wassergehalt im Ätzmittel durch die Zugabe von Phosphorpentoxid vor der Behandlung des Halbleitermaterials auf den gewünschten Wert gebracht. Dieser Wert kann auch unter dem Wert liegen, der durch Vermischen der wasserärmsten Einzelkomponenten zu erreichen ist. Während der Behandlung des Halbleitermaterials kann die Zugabe von Phosphorpentoxid in Abständen oder kontinuierlich geschehen. Vorteilhafterweise wird mindestens die Menge an Phosphorpentoxid zum Ätzmittel zugegeben, die zum Binden der während der Behandlung des Halbleitermaterials entstehenden Wassermenge erforderlich ist. Die Zugabe sollte so erfolgen, daß die Behandlung des Halbleitermaterials nicht gestört wird. Eine Störung wäre beispielsweise gegeben, wenn zugegebenes Phosphorpentoxid sich auf dem Halbleitermaterial absetzte. Dies läßt sich beispielsweise dadurch verhindern, daß ein Teil des Ätzmittels kurzzeitig abgezweigt und Phosphorpentoxid unter Bildung von Phosphorsäure zugemischt wird. Dieses Gemisch wird dann dem zur Behandlung von Halbleitermaterial verbliebenen Teil des Ätzmittels zugeführt.

Das Verfahren verwendet wasserarme Ätzmittel, die Flußsäure und mindestens einen Wirkstoff enthalten, der das zu behandelnde Halbleitermaterial zu oxidieren vermag, und die das Halbleitermaterial unter Bildung von Wasser angreifen. Besonders bevorzugt sind wasserarme Ätzmittel auf der Basis von Flußsäure und Salpetersäure. Das Ätzmittel kann gegebenenfalls eine oder mehrere weitere Komponenten enthalten, wobei diese aus einer Gruppe von Stoffen ausgewählt wird (werden), die Essigsäure, wässerige Ammoniumfluoridlösungen, Schwefelsäure, Salzsäure und Phosphorsäure umfaßt.

Die Zugabe von Phosphorpentoxid zum Ätzmittel eignet sich besonders zur naßchemischen Behandlung von Silicium. Das Verfahren kann jedoch auch zur Behandlung anderer Elementhalbleiter wie Germanium oder Verbindungshalbleiter wie Galliumarsenid mit Vorteil eingesetzt werden. Die Vorzüge des Verfahrens ergeben sich insbesondere beim als "chemisches Polieren" bezeichneten Ätzen von Siliciumscheiben. Die Zugabe von Phosphorpentoxid zum Ätzmittel verbessert die Geometrie der geätzten Scheiben und die Ebenheit ihrer Seitenflächen deutlich. Darüber hinaus zeichnet sich die Erfindung bei der Behandlung von Scheiben, Bruchstücken, Granulat und anderer Formkörper aus Halbleitermaterial dadurch aus, daß die Standzeiten des Ätzmittels verlängert, Anlagenkapazitäten erhöht und Hilfsstoffkosten reduziert werden können.

## Patentansprüche

1. Verfahren zur Behandlung von Halbleitermaterial mit einer säurehaltigen Flüssigkeit, wobei Wasser als Produkt einer chemischen Reaktion gebildet wird und die säurehaltige Flüssigkeit Wasser, Flußsäure und einen oxidierenden Wirkstoff enthält, dadurch gekennzeichnet, daß Phosphorpentoxid zur Begrenzung des Wassergehalts zur säurehaltigen Flüssigkeit zugegeben wird.

2. Verfahren nach Anspruch 1, dadurch gekennzeichnet, daß die Zugabe von Phosphorpentoxid vor der Behandlung des Halbleitermaterials erfolgt.

3. Verfahren gemäß Anspruch 1, dadurch gekennzeichnet, daß die Zugabe von Phosphorpentoxid während der Behandlung des Halbleitermaterials und kontinuierlich oder in Abständen erfolgt.

4. Verfahren nach einem der Ansprüche 1 bis 3, dadurch gekennzeichnet, daß durch die Zugabe von Phosphorpentoxid der Wassergehalt in der säurehaltigen Flüssigkeit unter 20 Gew.-% gehalten wird.

5. Verfahren nach einem der Ansprüche 1 bis 4, dadurch gekennzeichnet, daß die säurehaltige Flüssigkeit eine oder mehrere weitere Komponenten enthält, wobei diese aus einer Gruppe von Stoffen ausgewählt sind, die Essigsäure, wässerige Ammoniumfluoridlösungen, Schwefelsäure, Salzsäure und Phosphorsäure umfaßt.

## Claims

1. Process for treating semiconductor material with an acid-containing fluid, water being formed as product of a chemical reaction and the acid-containing fluid comprising water, hydrofluoric acid and an oxidizing agent, characterized in that phosphorus pentoxide is added to the acid-containing fluid to limit the water content.

2. Process according to Claim 1, characterized in that the addition of phosphorus pentoxide takes place before the treatment of the semiconductor material.

3. Process according to Claim 1, characterized in that the addition of phosphorus pentoxide takes place during the treatment of the semiconductor material and continuously or intermittently.

4. Process according to any one of Claims 1 to 3, characterized in that the addition of phosphorus pentoxide keeps the water content in the acid-containing fluid below 20 % by weight.

5. Process according to any one of Claims 1 to 4, characterized in that the acid-containing fluid comprises one or more further components selected from a group of substances which comprises acetic acid, aqueous ammonium fluoride solutions, sulphuric acid, hydrochloric acid and phosphoric acid.

## Revendications

1. Procédé pour le traitement de matériau semiconducteur à l'aide d'un liquide contenant de l'acide, dans lequel de l'eau se forme en tant que produit d'une réaction chimique et le liquide contenant de l'acide comprend de l'eau, de l'acide fluorhydrique et un agent oxydant, caractérisé en ce que l'on ajoute du pentoxyde de phosphore au liquide contenant de l'acide en vue de limiter la teneur en eau.

2. Procédé selon la revendication 1, caractérisé en ce que l'addition de pentoxyde de phosphore est effectuée avant le traitement du matériau semiconducteur.

3. Procédé selon la revendication 1, caractérisé en ce que l'addition de pentoxyde de phosphore est effectuée durant le traitement du matériau semiconducteur, et en continu ou par intervalles.

4. Procédé selon l'une quelconque des revendications 1 à 3, caractérisé en ce que la teneur en eau dans le liquide contenant de l'acide est maintenue en dessous de 20% en poids par l'addition de pentoxyde de phosphore.

5. Procédé selon l'une quelconque des revendications 1 à 4, caractérisé en ce que le liquide contenant de l'acide contient un ou plusieurs autres composants, ceux-ci étant choisis parmi un groupe de substances, qui comprend l'acide acétique, des solutions aqueuses de fluorure d'ammonium, l'acide sulfurique, l'acide chlorhydrique et l'acide phosphorique.
